# EUROPEAN PATENT APPLICATION

(11) **EP 3 654 378 A1**
(43) Date of publication of application: **20.05.2020**
(21) Application number: 18915778.7
(22) Date of filing: 19.09.2018
(51) Int. Cl.: H01L 27/24, C01B 35/04, H01L 45/00

(54) **MEMRISTOR ELECTRODE AND METHOD FOR MANUFACTURING SAME, MEMRISTOR, AND RESISTIVE RANDOM ACCESS MEMORY**

(71) Applicant: SHENZHEN GOODIX TECHNOLOGY CO., LTD., Shenzhen, Guangdong 518045 (CN)
(72) Inventor: YAO, Guofeng, Guangdong 518045 (CN); SHEN, Jian, Guangdong 518045 (CN)
(74) Representative: Herrero & Asociados, S.L.
(86) International application number: PCT/CN2018/106423
(87) International publication number: WO 2020/056617

(57) **Abstract**

Embodiments of the present application provide a memristor electrode and a method for producing the same, a memristor and a resistive memory (RRAM). The method includes: a. depositing a metal boride film on a substrate; b. performing annealing processing on the metal boride film; c. forming a photoresist layer on a surface of the metal boride film, and performing photolithography on the photoresist layer, to form a photolithographic pattern corresponding to a predetermined electrode pattern; and d. with the photolithographic pattern as a mask, etching the metal boride film by using an ion beam to form the metal boride film into the predetermined electrode pattern. According to the present invention, the memristor electrode produced using the metal boride is completely compatible with a CMOS producing process, and product performance of an RRAM including the memristor could be improved.

## Description

### TECHNICAL FIELD

Embodiments of the present application relate to the field of memory producing, and in particular, to a memristor electrode and a method for producing the same, a memristor and a resistive memory.

### BACKGROUND

A resistive random access memory (Resistive Random Access Memory, RRAM) is a kind of non-volatile (Non-volatile) memory that stores information by utilizing a variable resistance characteristic of a material, and has advantages of low power consumption, high density, fast reading and writing speed, high durability, and the like.

A basic storage cell of the RRAM is a memristor, which mainly includes a lower electrode, a resistive layer and an upper electrode. An access control cell of the RRAM is a metal-oxide-semiconductor field-effect transistor (Metal-Oxide-Semiconductor Field-Effect Transistor, MOSFET), which is a common device in a CMOS circuit. A working principle of the memristor is that: when a positive voltage is applied between the two electrodes, a conductive filament (Filament) is formed in the resistive layer, presenting a low resistance state; however, when a reset current (RESET current) is generated between the two electrodes, the conductive filament in the resistive layer is ruptured, presenting a high resistance state. Such variable resistance characteristic achieves an effect of switching of '0' and '1' in the RRAM.

The characteristic of the RRAM is largely determined by a material of an electrode. Generally, at least one electrode of the RRAM adopts an inert metal material with good conductivity and high work function (work function), for example, a noble metal such as platinum (Pt), iridium (Ir), gold (Au), palladium (Pd), and the like. However, these noble metal elements bring metal contamination to a front-end foundry (foundry) process. An RRAM producing process of an electrode using a noble metal material is incompatible with a standard CMOS producing process, which brings great difficulty to RRAM producing process integration. Therefore, many RRAM products adopt a foundry-friendly material such as titanium nitride (TiN) as an electrode, thereby avoiding a process integration problem caused by incompatible materials. Titanium nitride (TiN) is one of the most commonly used conductive materials in the foundry, and a producing method thereof includes metal organic chemical vapor deposition (MOCVD), physical vapor deposition (PVD), or the like, however, there is a certain gap between a material characteristic of TiN produced by the method and a requirement of the RRAM. However, due to a mature process of TiN, it has been widely used to produce the RRAM electrode; generally, technicians may improve RRAM performance by adjusting the resistive layer, adjusting a pulse width of a memristor operation or improving a design of an associated circuit. As a result, in a process of designing an RRAM product that meets the requirement, difficulty of a matching design related to the electrode is increased, and there will also be a higher probability that a finished RRAM product eventually fails to meet performance requirements.

### SUMMARY

Embodiments of the present application provide a memristor electrode and a method for producing the same, a memristor and a resistive memory, which could improve product performance of an RRAM on the basis of being compatible with a CMOS producing process.

According to a first aspect, provided is a method for producing a memristor electrode, including:
depositing a metal boride film on a substrate;
performing annealing processing on the metal boride film;
forming a photoresist layer on a surface of the metal boride film, and performing photolithography on the photoresist layer, to form a photolithographic pattern corresponding to a predetermined electrode pattern; and
with the photolithographic pattern as a mask, etching the metal boride film by using an ion beam to form the metal boride film into the predetermined electrode pattern.

Optionally, the metal boride film has a purity of 99.9% or more.

Optionally, the substrate is a silicon wafer.

Optionally, the metal boride film deposited on the substrate has a thickness of 20 nm to 100 nm.

Optionally, the annealing processing includes:
performing first annealing processing on the metal boride film at a first temperature for a first duration; and
performing second annealing processing on the metal boride film at a second temperature for a second duration, where the first temperature is higher than the second temperature and the first duration is shorter than the second duration.

Optionally, the first annealing processing is performed in nitrogen.

Optionally, the first temperature ranges from 900 °C to 1100 °C, and the first duration ranges from 1 second to 10 seconds.

Optionally, the second annealing processing is performed in a nitrogen-hydrogen mixed gas.

Optionally, the second temperature ranges from 400 °C to 430 °C, and the second duration ranges from 0.5 hour to 2 hours.

Optionally, a thickness of the photoresist layer is at least twice a thickness of the metal boride film.

Optionally, the etching the metal boride film by using the ion beam is: bombarding the surface of the metal boride film by using an inert gas ion to remove part of the metal boride film.

Optionally, the etching the metal boride film by using the ion has 10%-30% of over-etching.

Optionally, the metal boride has a hexagonal crystal structure, and a boron atom plane and a metal atom plane in the crystal structure alternate to form a two-dimensional network structure.

Optionally, the metal boride film is a metal diboride film.

Optionally, the metal boride film is any one of titanium diboride, zirconium diboride, hafnium diboride and magnesium diboride.

According to a second aspect, provided is a memristor electrode, which is produced according to the following producing method:
depositing a metal boride film on a substrate;
performing annealing processing on the metal boride film;
forming a photoresist layer on a surface of the metal boride film, and performing photolithography on the photoresist layer, to form a photolithographic pattern corresponding to a predetermined electrode pattern; and
with the photolithographic pattern as a mask, etching the metal boride film by using an ion beam to form the metal boride film into the predetermined electrode pattern.

According to a third aspect, provided is a memristor, including:
an upper electrode, a lower electrode and a resistive layer disposed between the upper electrode and the lower electrode, where the upper electrode and/or the lower electrode are produced according to the following producing method:
depositing a metal boride film on a substrate;
performing annealing processing on the metal boride film;
forming a photoresist layer on a surface of the metal boride film, and performing photolithography on the photoresist layer, to form a photolithographic pattern corresponding to a predetermined electrode pattern; and
with the photolithographic pattern as a mask, etching the metal boride film by using an ion beam to form the metal boride film into the predetermined electrode pattern.

According to a fourth aspect, provided is a resistive memory, including:
at least one memristor and a metal-oxide-semiconductor field-effect transistor (MOSFET) for controlling the memristor, the memristor including an upper electrode, a lower electrode and a resistive layer disposed between the upper electrode and the lower electrode, where the upper electrode and/or the lower electrode are produced according to the following producing method:
depositing a metal boride film on a substrate;
performing annealing processing on the metal boride film;
forming a photoresist layer on a surface of the metal boride film, and performing photolithography on the photoresist layer, to form a photolithographic pattern corresponding to a predetermined electrode pattern; and
with the photolithographic pattern as a mask, etching the metal boride film by using an ion beam to form the metal boride film into the predetermined electrode pattern.

Optionally, the metal-oxide-semiconductor field-effect transistor includes a substrate, a source, a drain, a gate dielectric layer, a gate, and a spacer.

Optionally, the drain is electrically connected with the lower electrode through a first metal connection line.

Optionally, the resistive memory includes a plurality of memristors arranged in a matrix form.

Optionally, upper electrodes of the plurality of memristors arranged in the matrix form in a same row/column are respectively connected to a plurality of second metal connection lines in one-to-one correspondence, and the plurality of second metal connection lines are connected with an external circuit/ground terminal through a third metal connection line.

Optionally, the external circuit includes a row/column decoder, a write circuit, and/or an amplification circuit.

According to the electrode of the resistive memory provided by the embodiment of the invention, a metal boride is used as an electrode material, which could be compatible with a CMOS process, and could improve performance of the resistive memory, thereby reducing difficulty in designing the resistive memory material and an associated circuit, and enabling industrial utilization of the resistive memory more operable.

### BRIEF DESCRIPTION OF DRAWINGS

FIG. 1 is a 2x2 memory array of resistive memories of the present application.
FIG. 2 is an enlarged schematic diagram of a single memristor in a memory array of resistive memories of the present application.
FIG. 3 is a schematic equivalent circuit diagram of a resistive memory according to an embodiment of the present application.
FIG. 4 is a schematic structural diagram of a resistive memory according to an embodiment of the present application.
FIG. 5 is a perspective view of a hexagonal structure of titanium diboride crystal used for producing a memristor electrode of the present application.
FIG. 6 is a plan view of a hexagonal structure of titanium diboride crystal used for producing a memristor electrode of the present application.
FIG. 7 is a schematic flowchart of a method for producing a metal boride electrode of a memristor of the present application.
FIG. 8 is a schematic flowchart of another embodiment of a method for producing a metal boride electrode of a memristor of the present application.
FIG. 9 is a schematic flowchart of yet another embodiment of a method for producing a metal boride electrode of a memristor of the present application.
FIG. 10 is a schematic flowchart of a method for producing a titanium diboride electrode of a memristor of the present application.
FIG. 11 is a schematic flowchart of another embodiment of a method for producing a titanium diboride electrode of a memristor of the present application.
FIG. 12 is a schematic flowchart of yet another embodiment of a method for producing a titanium diboride electrode of a memristor of the present application.

### DESCRIPTION OF EMBODIMENTS

To make the objectives, technical solutions, and advantages of embodiments of the present invention clearer, the following clearly and completely describes the technical solutions in the embodiments of the present invention with reference to the accompanying drawings in the embodiments of the present invention. Apparently, the described embodiments are some but not all of the embodiments of the present invention. All other embodiments obtained by a person of ordinary skill in the art based on the embodiments of the present disclosure without creative efforts shall fall within the protection scope of the present disclosure.

Terms "first", "second", "third", "fourth" and the like (if they exist) in the description and claims of the present invention and the above accompany drawings are used for distinguishing similar objects, but are not necessarily used for describing a particular order or a precedence order. It should be understood that data used in such a manner may be exchanged under appropriate circumstances, so that the embodiments of the present invention described herein can be implemented in other sequences besides these sequences as shown in the figures or described herein, for example. In addition, the terms "including" and "having" and any deformations thereof, are intended to cover non-exclusive inclusion, for example, processes, methods, systems, products or devices containing a series of steps or units are not necessarily limited to these clearly listed steps or units, but may include other steps or units, which are not clearly listed or inherent to these processes, methods, systems, products or devices.

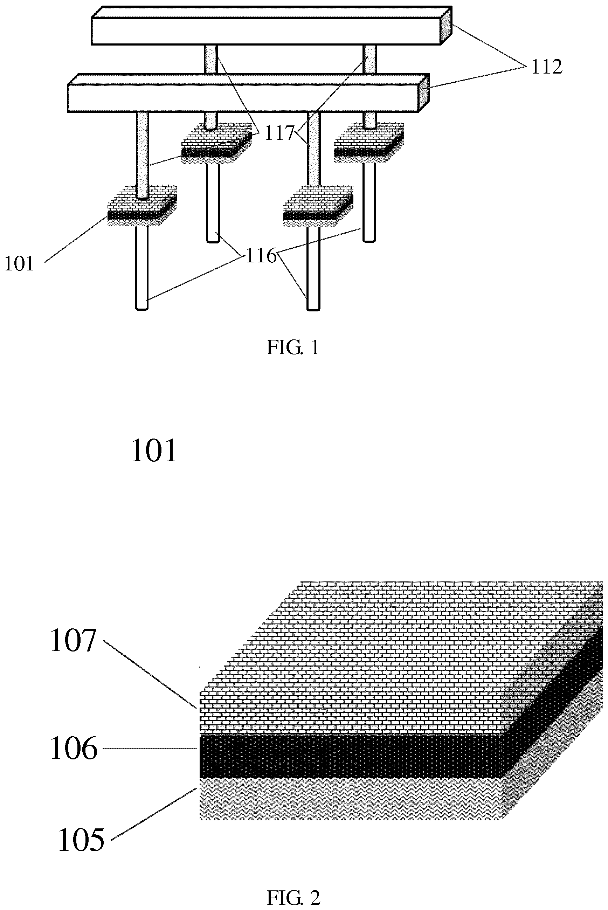

A basic storage cell of an RRAM is a memristor. FIG. 1 is a simplified schematic diagram of a 2×2 memory array of resistive memories, and FIG. 2 is an enlarged schematic diagram of a single memristor in an RRAM memory array. A memristor 101 may include a lower electrode 105, a resistive layer 106, and an upper electrode 107, and the resistive layer 106 is made of a resistive material and is disposed between the upper electrode 107 and the lower electrode 105. The lower electrode 105 of the memristor 101 may be connected to a first metal connection line 116. The upper electrodes 107 of a plurality of memristors 101 in a same row (or a same column) may be connected with a third metal connection line 112 through respective corresponding second metal connection lines 117, and connected with an external circuit or a ground terminal through the third metal connection line 112; and the external circuit may include a row/column decoder, a write circuit, and/or an amplification circuit.

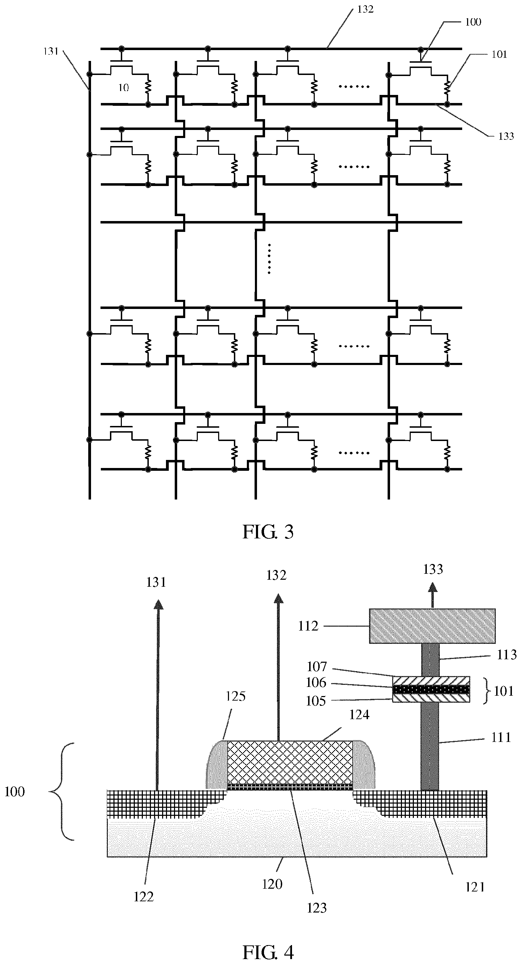

FIG. 3 is a schematic equivalent circuit diagram of a resistive memory provided by an embodiment of the present invention. The resistive memory may be an m^{∗}n memory matrix, that is, it includes m^{∗}n basic memory cells (or basic cells). A basic cell 10 includes a MOSFET 100 and a memristor 101, where a drain of the MOSFET 100 is connected to one end (for example, a lower electrode) of the memristor 101, the other end (for example, an upper electrode) of the memristor 101 is connected to a bit line 133 (Bit Line, BL), a source of the MOSFET 100 is connected to a source line 131 (Source Line, SL), and a gate of the MOSFET 100 is connected to a word line 132 (Word Line, WL). Addressing of each basic cell may be jointly defined by the word line (WL) 132 and the bit line (BL) 133. In one example, the bit line 133 may be the third metal connection line 112 shown in FIG. 1.

FIG. 4 is a schematic structural diagram of a resistive memory. As shown in FIG. 4, a MOSFET for controlling a memristor includes a substrate (Substrate) 120, a source (Source) 122, a drain (Drain) 121, a gate dielectric (Gate dielectrics) layer 123, a gate (Gate) 124, and a spacer (Spacer) 125. The drain 121 is electrically connected with a lower electrode 105 of a memristor 101 through a first metal connection line formed in a first via (Via) 111. A resistive layer 106 is disposed between the lower electrode 105 and an upper electrode 107 of the memristor 101, the upper electrode 107 of the memristor 101 is connected to a second metal connection line formed in a second via (Via) 113; the second metal connection line formed in the second via 113 in a same row/column is connected to a third metal connection line 112. The third metal connection line 112 is connected to a bit line 133, which may also be connected to an external circuit including a row/column decoder, a write circuit and an amplification circuit. The source 122 is connected to a source line 131, and the gate 124 is connected to a word line (WL) 132.

In the present application, upper electrodes of a plurality of memristors in a same row/column may also be connected with a third metal connection line through a second metal connection line, and the third metal connection line is connected with an external circuit. The external circuit includes a row/column decoder, a write circuit, and an amplification circuit.

In related fields, a metal boride is only considered as a structural material, often used as super-hard coating and corrosion-resistant coating, but rarely used as a simple conductive material.

An embodiment of the present invention provides a memristor electrode and a method for producing the same. An electrode material of the memristor adopts a metal boride. The metal boride has a hexagonal crystal structure, and a boron atom plane and a metal atom plane in the crystal structure alternate to form a two-dimensional network structure. The layered structure of a boron atom and an outer layer electron of a metal determine that the metal boride has good conductivity. A metal boride material has better conductivity, oxidation resistance and work function than those of an existing titanium nitride material.

In one possible embodiment, the metal boride used to produce the electrode of the memristor may be titanium diboride (TiB₂).

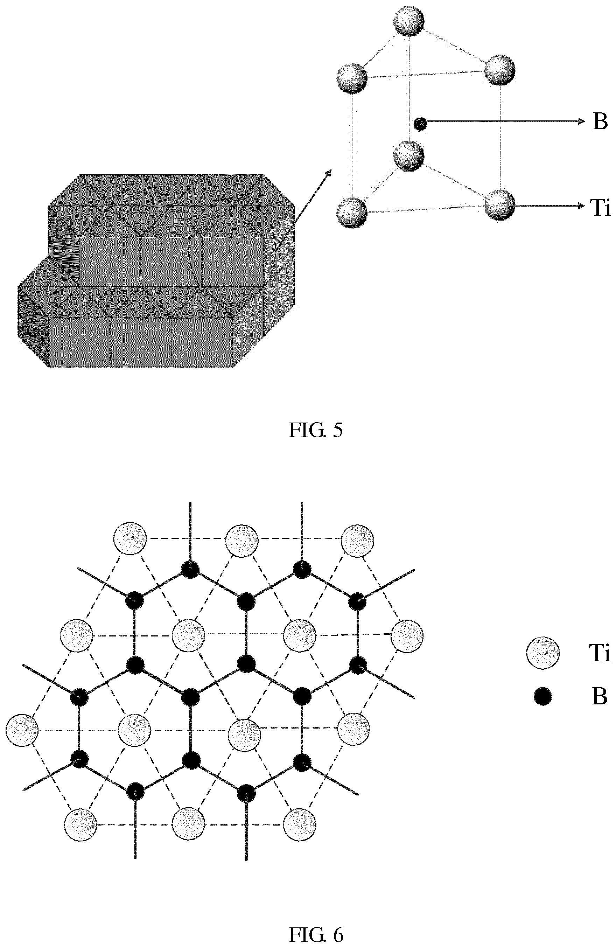

FIG. 5 is a perspective view of a crystal structure of titanium diboride, and FIG. 6 is a plan view of a crystal structure of titanium diboride. Conductivity of titanium diboride is related to its structure. TiB₂ has a hexagonal crystal structure, in which a boron atom plane and a titanium atom plane alternate to form a two-dimensional network structure, as shown in FIG. 5. One B atom is combined with the other three B atoms by a covalent bond, and one extra electron forms a large π bond. The layered structure of the B atom similar to graphite and an outer layer electron of Ti determine that TiB₂ has good conductivity, and its resistivity is 14.4 µΩ•cm, which is better than resistivity of titanium nitride, that is, 22 µΩ•cm. In addition, titanium diboride is resistant to high temperature with the melting point of 2980 °C, and an oxidation resistance temperature in air up to 1000 °C, and it has excellent oxidation resistance and thermal shock resistance, which are also better than titanium nitride. The work function of titanium nitride is about 4.6 eV, while the work function of titanium diboride is 4.75 eV ∼5 eV. Therefore, from three aspects of resistivity, chemical stability and work function, it is possible to obtain better device performance than an existing titanium nitride material by using titanium diboride as an electrode material of an RRAM.

In the embodiment of the present application, the titanium diboride (TiB₂) is only one of metal borides, by way of example and not limitation, it may also be other metal borides having a similar crystal structure and property, such as zirconium diboride, hafnium diboride, magnesium diboride, and the like, which are not limited in the embodiment of the present application.

Boron and titanium are common elements in a wafer foundry producing process, so titanium diboride is completely compatible with a CMOS producing process.

In the embodiment of the present application, titanium diboride used for producing the memristor electrode is compatible with the CMOS producing process, and other metal borides such as zirconium diboride, hafnium diboride, magnesium diboride, and the like are also compatible with the CMOS producing process, which is not limited in the embodiment of the present application.

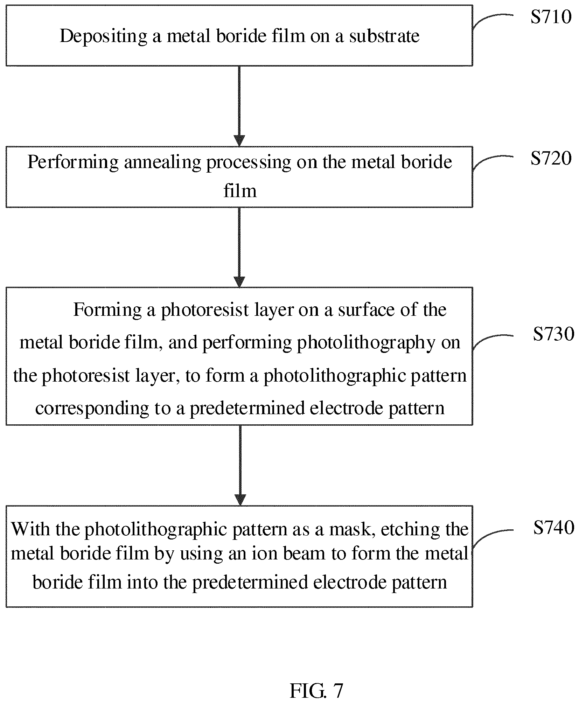

Hereinafter, a method for producing a metal boride electrode of an RRAM memristor cell according to an embodiment of the present application will be described in detail with reference to FIGS. 7 to 12.

The following embodiments may be used to produce an upper electrode of the memristor, a lower electrode of the memristor, and the upper electrode and the lower electrode of the memristor at the same time, which is not limited in the embodiment of the present application.

FIG. 7 is a schematic flowchart of a method for producing a metal boride electrode of a resistive memory RRAM according to an embodiment of the present application.

It should be understood that FIG. 7 shows main steps or operations of the method for producing the metal boride electrode of the embodiment of the present application, but these steps or operations are only examples, the embodiment of the present application may also perform other operations or variations of the various operations of FIG. 7, and it is possible that not all operations in the embodiment of the method are performed, nor are they performed in the order of the described steps.

As shown in FIG. 7, the method may include:
S710, a metal boride film is deposited on a substrate.

The substrate may be a silicon wafer, specifically, the silicon wafer may be a substrate on which a metal-oxide-semiconductor field-effect transistor (MOSFET) circuit has been produced, a drain is electrically connected with a lower electrode of a memristor through a first metal connection line in a first via, an upper electrode of the memristor in a same row/column is connected with a third metal connection line through a second metal connection line in a second via, the third metal connection line is connected with an external circuit, and the silicon wafer may also be a bare substrate, which is not limited in the present application.

Specifically, a thickness of the metal boride film as an RRAM electrode may range from 20 nm to 100 nm.

Optionally, the metal boride film may be deposited using a deposition process, which may be, for example, a physical vapor deposition (Physical Vapor Deposition, PVD) process, an atomic layer deposition (Atomic layer deposition, ALD) process, a chemical vapor deposition (Chemical Vapor Deposition, CVD) process, and the like, and the embodiment of the present application is not limited thereto.

S720, annealing processing is performed on the metal boride film.

As the metal boride film that just has been deposited has relatively large resistivity, annealing is needed to reduce the resistivity.

Specifically, the annealing processing includes: performing first annealing processing on the metal boride film at a first temperature for a first duration; and performing second annealing processing on the metal boride film at a second temperature for a second duration, where the first temperature is higher than the second temperature and the first duration is shorter than the second duration. The first annealing processing is performed in nitrogen, and the first temperature ranges from 900 °C to 1100 °C, and the first duration ranges from 1 second to 10 seconds. The second annealing processing is performed in a nitrogen-hydrogen mixed gas, and the second temperature ranges from 400 °C to 430 °C, and the second duration ranges from 0.5 hour to 2 hours.

S730, a photoresist layer is formed on a surface of the metal boride film, and photolithography is performed on the photoresist layer, to form a photolithographic pattern corresponding to a predetermined electrode pattern.

Optionally, the photoresist may be a positive photoresist or a negative photoresist, which is not limited in the embodiment of the present application.

Specifically, a thickness of the photoresist is at least twice that of the metal boride film. Optionally, an electrode pattern may be a square, a circle or other shapes, which is not limited in the embodiment of the present application.

Specifically, a size of the electrode pattern is a size of a minimum side length, for example, for a circle, a size of the electrode pattern may be a diameter.

S740, with the photolithographic pattern as a mask, the metal boride film is etched by using an ion beam to form the metal boride film into the predetermined electrode pattern.

Optionally, the ion may be an inert gas ion, and the inert gas ion may be an argon ion, a xenon ion, or other inert gas ions, which is not limited in the embodiment of the present application.

Specifically, due to a stable chemical property of titanium diboride, conventional reactive etching is difficult to remove, and an argon ion is used to bombard the surface of the metal boride at a non-electrode region to remove the material layer by layer, and this process may have 10%-30% of over-etching. Thus, the metal boride at the non-electrode region is ensured to be removed completely, leaving a required metal boride electrode pattern.

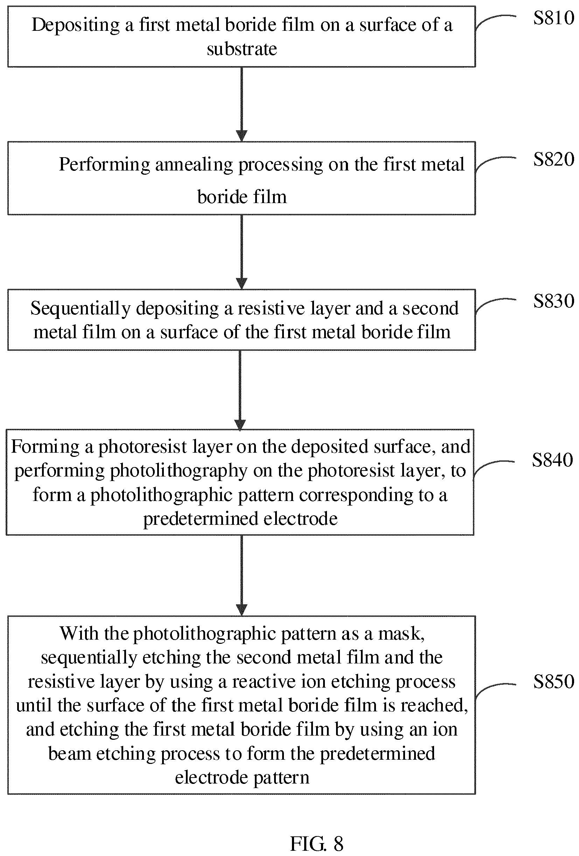

The present invention also provides an embodiment of a method for producing a memristor, as shown in FIG. 8, including:
S810, a first metal boride film is deposited on a surface of a substrate.

The substrate may be a silicon wafer, specifically, the silicon wafer may be a substrate on which a metal-oxide-semiconductor field-effect transistor (MOSFET) circuit has been produced, a drain is electrically connected with a lower electrode of a memristor through a first metal connection line in a first via, an upper electrode of the memristor in a same row/column is connected with a third metal connection line through a second metal connection line in a second via, the third metal connection line is connected with an external circuit, and the silicon wafer may also be a bare substrate, which is not limited in the present application.

Specifically, a thickness of the first metal boride film as an RRAM electrode may range from 20 nm to 100 nm.

Optionally, the first metal boride film may be deposited using a deposition process, which may be, for example, a physical vapor deposition (Physical Vapor Deposition, PVD) process, an atomic layer deposition (Atomic layer deposition, ALD) process, a chemical vapor deposition (Chemical Vapor Deposition, CVD) process, and the like, and the embodiment of the present application is not limited thereto.

S820, annealing processing is performed on the first metal boride film.

Specifically, the annealing processing includes: performing first annealing processing on the first metal boride film at a first temperature for a first duration; and performing second annealing processing on the first metal boride film at a second temperature for a second duration, where the first temperature is higher than the second temperature and the first duration is shorter than the second duration. The first annealing processing is performed in nitrogen, and the first temperature ranges from 900 °C to 1100 °C, and the first duration ranges from 1 second to 10 seconds. The second annealing processing is performed in a nitrogen-hydrogen mixed gas, and the second temperature ranges from 400 °C to 430 °C, and the second duration ranges from 0.5 hour to 2 hours.

S830, a resistive layer and a second metal film is sequentially deposited on a surface of the first metal boride film.

In the embodiment of the present application, a material of the second metal film may be any one of titanium, tantalum, titanium nitride, tantalum nitride, and a metal boride, which is not limited in the embodiment of the present application.

Optionally, the resistive layer and the second metal film may be deposited using a deposition process, which may be, for example, a physical vapor deposition (Physical Vapor Deposition, PVD) process, an atomic layer deposition (Atomic layer deposition, ALD) process, a chemical vapor deposition (Chemical Vapor Deposition, CVD) process, and the like, and the embodiment of the present application is not limited thereto.

S840, a photoresist layer is formed on the deposited surface, and photolithography is performed on the photoresist layer, to form a photolithographic pattern corresponding to a predetermined electrode pattern.

Optionally, the photoresist may be a positive photoresist or a negative photoresist, which is not limited in the embodiment of the present application.

Specifically, a thickness of the photoresist is at least twice that of the first metal boride film.

Optionally, an electrode pattern may be a square, a circle or other shapes, which is not limited in the embodiment of the present application.

Specifically, a size of the electrode pattern is a size of a minimum side length, for example, for a circle, a size of the electrode pattern may be a diameter.

S850, with the photolithographic pattern as a mask, the second metal film and the resistive layer are sequentially etched by using a reactive ion etching process until the surface of the first metal boride film is reached. The first metal boride film is etched by using an ion beam etching process to form the predetermined electrode pattern.

Optionally, a first metal boride may be etched by using an inert gas ion, and the inert gas ion may be an argon ion, a xenon ion, or other inert gas ions, which is not limited in the embodiment of the present application.

Specifically, an argon ion is used to bombard the surface of the first metal boride film at a non-electrode region to remove the material layer by layer, and this process may have 10%-30% of over-etching.

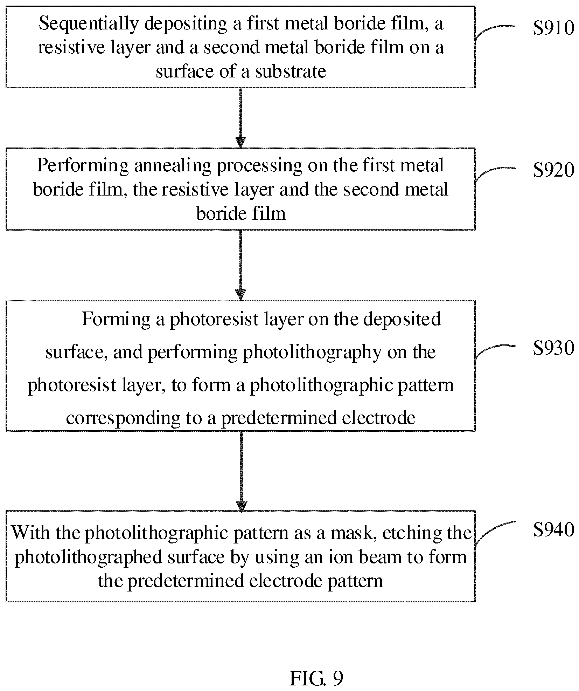

The present invention also provides an embodiment of another method for producing a memristor, as shown in FIG. 9, including:
S910, a first metal boride film, a resistive layer and a second metal boride film are sequentially deposited on a surface of a substrate.

The substrate may be a silicon wafer, specifically, the silicon wafer may be a substrate on which a metal-oxide-semiconductor field-effect transistor (MOSFET) circuit has been produced, a drain is electrically connected with a lower electrode of a memristor through a first metal connection line in a first via, an upper electrode of the memristor in a same row/column is connected with a third metal connection line through a second metal connection line in a second via, the third metal connection line is connected with an external circuit, and the silicon wafer may also be a bare substrate, which is not limited in the present application.

Specifically, a thickness of a first metal boride film and a second metal boride film as an RRAM electrode may range from 20 nm to 100 nm.

Optionally, the first metal boride film, a resistive material layer and the second metal boride film may be deposited using a deposition process, which may be, for example, a physical vapor deposition (Physical Vapor Deposition, PVD) process, an atomic layer deposition (Atomic layer deposition, ALD) process, a chemical vapor deposition (Chemical Vapor Deposition, CVD) process, and the like, and the embodiment of the present application is not limited thereto.

S920, annealing processing is performed on the first metal boride film, the resistive layer and the second metal boride film.

Specifically, the annealing processing includes: performing first annealing processing on the first metal boride film, the resistive material layer and the second metal boride film at a first temperature for a first duration; and performing second annealing processing on the first metal boride film, the resistive material layer and the second metal boride film at a second temperature for a second duration, where the first temperature is higher than the second temperature and the first duration is shorter than the second duration. The first annealing processing is performed in nitrogen, and the first temperature ranges from 900 °C to 1100 °C, and the first duration ranges from 1 second to 10 seconds. The second annealing processing is performed in a nitrogen-hydrogen mixed gas, and the second temperature ranges from 400 °C to 430 °C, and the second duration ranges from 0.5 hour to 2 hours.

S930, a photoresist layer is formed on the deposited surface, and photolithography is performed on the photoresist layer, to form a photolithographic pattern corresponding to a predetermined electrode pattern.

Optionally, the photoresist may be a positive photoresist or a negative photoresist, which is not limited in the embodiment of the present application.

Specifically, a thickness of the photoresist is at least twice that of the first metal boride film or the second metal boride film.

Optionally, an electrode pattern may be square, a circle or other shapes, which is not limited in the embodiment of the present application.

Specifically, a size of the electrode pattern is a size of a minimum side length, for example, for a circle, a size of the electrode pattern may be a diameter.

S940, with the photolithographic pattern as a mask, the photolithographed surface is etched by using an ion beam to form the predetermined electrode pattern.

Optionally, the ion may be an inert gas ion, and the inert gas ion may be an argon ion, a xenon ion, or other inert gas ions, which is not limited in the embodiment of the present application.

Specifically, an argon ion is used to bombard the surface of the first metal boride film and the second metal boride film at a non-electrode region to remove the material layer by layer, and this process may have 10%-30% of over-etching.

In another embodiment, other producing methods can be used to produce the memristor electrode using titanium diboride. In a CMOS foundry, all targets are metals or alloys, for example, as for titanium nitride, metallic titanium is used as a target and then nitriding is performed. The metal boride is produced by a special ceramic target or ceramic powder, so that a producing process of titanium diboride greatly differs from that of titanium nitride.

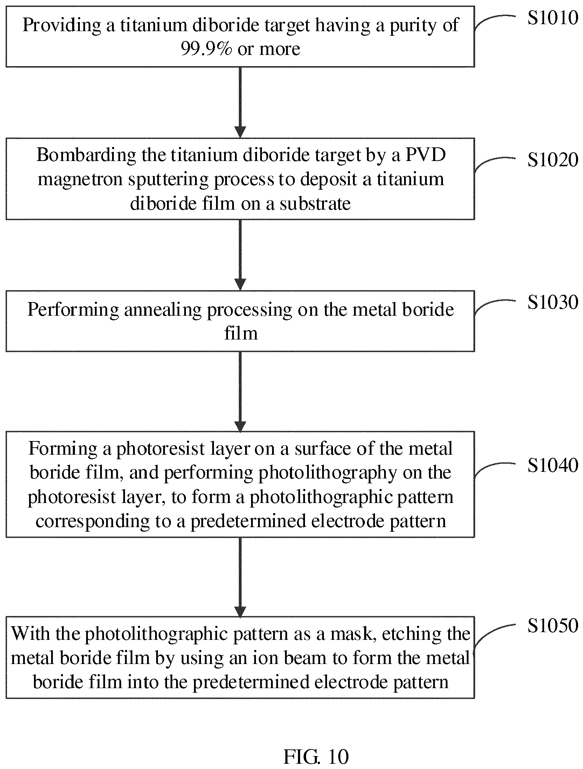

As shown in FIG. 10, a method for producing a titanium diboride electrode of a resistive memory may include:
S1010, a titanium diboride target having a purity of 99.9% or more is provided.

Specifically, the titanium diboride target may be sintered by a powder metallurgy process.

S1020, the titanium diboride target is bombarded by a PVD magnetron sputtering process to deposit a titanium diboride film on a substrate.

The substrate may be a silicon wafer, specifically, the silicon wafer may be a substrate on which a metal-oxide-semiconductor field-effect transistor (MOSFET) circuit has been produced, a drain is electrically connected with a lower electrode of a memristor through a first metal connection line in a first via, an upper electrode of the memristor in a same row/column is connected with a third metal connection line through a second metal connection line in a second via, the third metal connection line is connected with an external circuit, and the silicon wafer may also be a bare substrate, which is not limited in the present application.

Specifically, a thickness of a metal boride film as an RRAM electrode may range from 20 nm to 100 nm.

S1030, annealing processing is performed on the metal boride film.

Specifically, the annealing processing includes: performing first annealing processing on the metal boride film at a first temperature for a first duration; and performing second annealing processing on the metal boride film at a second temperature for a second duration, where the first temperature is higher than the second temperature and the first duration is shorter than the second duration. The first annealing processing is performed in nitrogen, and the first temperature ranges from 900 °C to 1100 °C, and the first duration ranges from 1 second to 10 seconds. The second annealing processing is performed in a nitrogen-hydrogen mixed gas, and the second temperature ranges from 400 °C to 430 °C, and the second duration ranges from 0.5 hour to 2 hours.

S1040, a photoresist layer is formed on a surface of the metal boride film, and photolithography is performed on the photoresist layer, to form a photolithographic pattern corresponding to a predetermined electrode pattern.

Optionally, the photoresist may be a positive photoresist or a negative photoresist, which is not limited in the embodiment of the present application.

Specifically, a thickness of the photoresist is at least twice that of the metal boride film.

Optionally, an electrode pattern may be a square, a circle or other shapes, which is not limited in the embodiment of the present application.

Specifically, a size of the electrode pattern is a size of a minimum side length, for example, for a circle, a size of the electrode pattern may be a diameter.

S1050, with the photolithographic pattern as a mask, the metal boride film is etched by using an ion beam to form the metal boride film into the predetermined electrode pattern.

Optionally, the ion may be an inert gas ion, and the inert gas ion may be an argon ion, a xenon ion, or other inert gas ions, which is not limited in the embodiment of the present application.

Specifically, due to a stable chemical property of titanium diboride, conventional reactive etching is difficult to remove, and an argon ion is used to bombard the surface of the metal boride at a non-electrode region to remove the material layer by layer, and this process may have 10%-30% of over-etching. Thus, the metal boride at the non-electrode region is ensured to be removed completely, leaving a required metal boride electrode pattern.

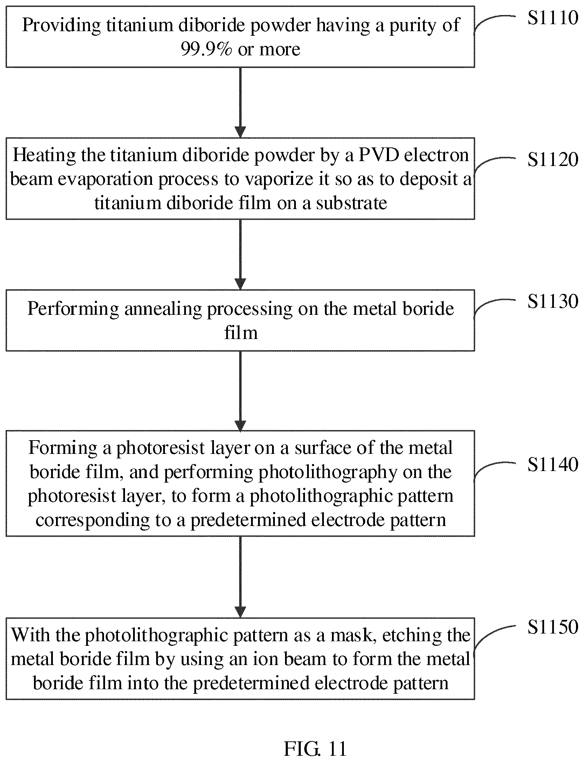

In another embodiment, as shown in FIG. 11, a method for producing a titanium diboride electrode of a resistive memory may further include:
S1110, titanium diboride powder having a purity of 99.9% or more is provided.
S1120, the titanium diboride powder is heated by a PVD electron beam evaporation process to vaporize it so as to deposit a titanium diboride film on a substrate.

The substrate may be a silicon wafer, specifically, the silicon wafer may be a substrate on which a metal-oxide-semiconductor field-effect transistor (MOSFET) circuit has been produced, a drain is electrically connected with a lower electrode of a memristor through a first metal connection line in a first via, an upper electrode of the memristor in a same row/column is connected with a third metal connection line through a second metal connection line in a second via, the third metal connection line is connected with an external circuit, and the silicon wafer may also be a bare substrate, which is not limited in the present application.

Specifically, a thickness of a metal boride film as an RRAM electrode may range from 20 nm to 100 nm.

SI130, annealing processing is performed on the metal boride film.

Specifically, the annealing processing includes: performing first annealing processing on the metal boride film at a first temperature for a first duration; and performing second annealing processing on the metal boride film at a second temperature for a second duration, where the first temperature is higher than the second temperature and the first duration is shorter than the second duration. The first annealing processing is performed in nitrogen, and the first temperature ranges from 900 °C to 1100 °C, and the first duration ranges from 1 second to 10 seconds. The second annealing processing is performed in a nitrogen-hydrogen mixed gas, and the second temperature ranges from 400 °C to 430 °C, and the second duration ranges from 0.5 hour to 2 hours.

S1140, a photoresist layer is formed on a surface of the metal boride film, and photolithography is performed on the photoresist layer, to form a photolithographic pattern corresponding to a predetermined electrode pattern.

Optionally, the photoresist may be a positive photoresist or a negative photoresist, which is not limited in the embodiment of the present application.

Specifically, a thickness of the photoresist is at least twice that of the metal boride film.

Optionally, an electrode pattern may be a square, a circle or other shapes, which is not limited in the embodiment of the present application.

Specifically, a size of the electrode pattern is a size of a minimum side length, for example, for a circle, a size of the electrode pattern may be a diameter.

S1150, with the photolithographic pattern as a mask, the metal boride film is etched by using an ion beam to form the metal boride film into the predetermined electrode pattern.

Optionally, the ion may be an inert gas ion, and the inert gas ion may be an argon ion, a xenon ion, or other inert gas ions, which is not limited in the embodiment of the present application.

Specifically, due to a stable chemical property of titanium diboride, conventional reactive etching is difficult to remove, and an argon ion is used to bombard the surface of the metal boride at a non-electrode region to remove the material layer by layer, and this process may have 10%-30% of over-etching. Thus, the metal boride at the non-electrode region is ensured to be removed completely, leaving a required metal boride electrode pattern.

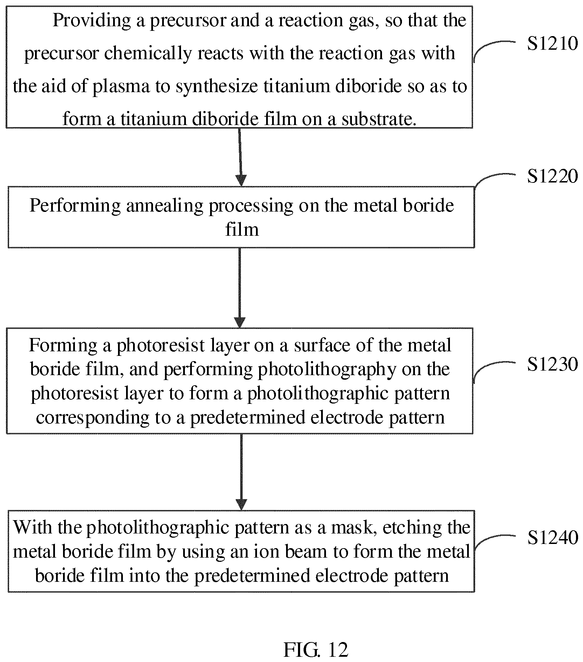

In yet another possible embodiment, as shown in FIG. 12, a method for producing a titanium diboride electrode of a resistive memory may further include:
S1210, a precursor and a reaction gas are provided, so that the precursor chemically reacts with the reaction gas with the aid of plasma to synthesize titanium diboride so as to form a titanium diboride film on a substrate.

Specifically, in a process of producing an electrode material of an RRAM, the precursor adopted may be an inorganic compound as much as possible so as to avoid carbon residue on the electrode.

Optionally, in the embodiment of the present application, the precursor may be TiCl₄ and BCl₃, and the reaction gas may be H₂; the precursor may also be TiCl₄ and the reaction gas may be BH₃. The precursor and the reaction gas may also be other substances for synthesizing the titanium diboride film, which is not limited in the embodiment of the present application.

In the present application, a type of the precursor, a type of the reaction gas, and whether the Ti element or B element is derived from the precursor gas or the reaction gas are not limited.

The substrate may be a silicon wafer, specifically, the silicon wafer may be a substrate on which a metal-oxide-semiconductor field-effect transistor (MOSFET) circuit has been produced, a drain is electrically connected with a lower electrode of a memristor through a first metal connection line in a first via, an upper electrode of the memristor in a same row/column is connected with a third metal connection line through a second metal connection line in a second via, the third metal connection line is connected with an external circuit, and the silicon wafer may also be a bare substrate, which is not limited in the present application.

Specifically, a thickness of a metal boride film as an RRAM electrode may range from 20 nm to 100 nm.

Optionally, a chemical synthesis process for depositing the titanium diboride film on the substrate may be a chemical vapor deposition (CVD) or an atomic layer deposition (ALD), which is not limited in the embodiment of the present application.

Specifically, both the CVD and the ALD are similar in process principle, that is, the precursor reacts with the reaction gas with the aid of plasma to finally obtain a product.

S1220, annealing processing is performed on the metal boride film.

Specifically, the annealing processing includes: performing first annealing processing on the metal boride film at a first temperature for a first duration; and performing second annealing processing on the metal boride film at a second temperature for a second duration, where the first temperature is higher than the second temperature and the first duration is shorter than the second duration. The first annealing processing is performed in nitrogen, and the first temperature ranges from 900 °C to 1100 °C, and the first duration ranges from 1 second to 10 seconds. The second annealing processing is performed in a nitrogen-hydrogen mixed gas, and the second temperature ranges from 400 °C to 430 °C, and the second duration ranges from 0.5 hour to 2 hours.

S1230, a photoresist layer is formed on a surface of the metal boride film, and photolithography is performed on the photoresist layer, to form a photolithographic pattern corresponding to a predetermined electrode pattern.

Optionally, the photoresist may be a positive photoresist or a negative photoresist, which is not limited in the embodiment of the present application.

Specifically, a thickness of the photoresist is at least twice that of the metal boride film.

Optionally, an electrode pattern may be a square, a circle or other shapes, which is not limited in the embodiment of the present application.

Specifically, a size of the electrode pattern is a size of a minimum side length, for example, for a circle, a size of the electrode pattern may be a diameter.

S1240, with the photolithographic pattern as a mask, the metal boride film is etched by using an ion beam to form the metal boride film into the predetermined electrode pattern.

Optionally, the ion may be an inert gas ion, and the inert gas ion may be an argon ion, a xenon ion, or other inert gas ions, which is not limited in the embodiment of the present application.

Specifically, due to a stable chemical property of titanium diboride, conventional reactive etching is difficult to remove, and an argon ion is used to bombard the surface of the metal boride at a non-electrode region to remove the material layer by layer, and this process may have 10%-30% of over-etching. Thus, the metal boride at the non-electrode region is ensured to be removed completely, leaving a required metal boride electrode pattern.

Specifically, a titanium diboride film is deposited on a substrate by a CVD or ALD deposition process, and process parameters such as a flow rate of each component gas, a plasma process, an air pressure and the like need to be optimized, so that the titanium diboride film conforms to a stoichiometric ratio, thereby making the performance optimal.

Specifically, as for preparing the titanium diboride film by a chemical method, both CVD and ALD processes have respective advantages, the CVD process has a faster film deposition rate and higher efficiency, and the ALD process controls the stoichiometric ratio more accurate.

The method for producing the titanium diboride electrode of the RRAM memristor in the embodiment of the present application improves endurance of the RRAM and product performance of the RRAM.

It should be noted that FIGS. 7 to 12 illustrate possible implementation manners of the method for producing the titanium diboride electrode of the RRAM memristor according to the embodiment of the present application, or in a preferred implementation manner, the method may also produce metal borides such as zirconium diboride, hafnium diboride, magnesium diboride, or the like, which is not limited in the embodiment of the present application. Other methods for producing a resistive metal boride electrode obtained by the method for producing the titanium diboride electrode of the resistive memory according to the embodiment of the present application also fall within the protection scope of the embodiment of the present application. It should be understood that, the method for producing the resistive electrode according to the embodiment of the present application may also be other alternative or equivalent variation modifications of various operations in the foregoing steps, and the embodiment of the present application is not limited to the operation process or operation manner used by each step.

It should also be understood that, each embodiment of the resistive electrode producing methods listed above may be performed by a robot or numerical control machine. The device software or process for performing the resistive electrode producing methods may perform the foregoing resistive electrode producing methods by executing the computer program code stored in the memory.

It should be understood that sequence numbers of the foregoing processes do not mean execution sequences in the embodiments of the present application. The execution sequences of the processes should be determined according to functions and internal logic of the processes, and should not be construed as any limitation on the implementation processes of the embodiments of the present application.

Those of ordinary skill in the art may be aware that, units and algorithm steps of the examples described in the embodiments disclosed in this paper may be implemented by electronic hardware, computer software, or a combination of the two. Whether these functions are performed by hardware or software depends on particular applications and designed constraint conditions of the technical solutions. Persons skilled in the art may use different methods to implement the described functions for each particular application, but it should not be considered that the implementation goes beyond the scope of the present application.

The units described as separate components may or may not be physically separate, and components displayed as units may or may not be physical units, may be located in one position, or may be distributed on multiple network units. Some or all of the units may be selected according to actual requirements to achieve the objectives of the solutions of the embodiments.

In addition, functional units in the embodiments of this application may be integrated into one processing unit, or each of the units may exist alone physically, or two or more units are integrated into one unit.

The foregoing descriptions are merely specific embodiments of the present application, but the protection scope of the present application is not limited thereto, persons skilled in the art who are familiar with the art could readily think of variations or substitutions within the technical scope disclosed by the present application, and these variations or substitutions shall fall within the protection scope of the present application. Therefore, the protection scope of the present application shall be subject to the protection scope of the claims.

## Claims

1. A method for producing a memristor electrode, comprising:
depositing a metal boride film on a substrate;
performing annealing processing on the metal boride film;
forming a photoresist layer on a surface of the metal boride film, and performing photolithography on the photoresist layer, to form a photolithographic pattern corresponding to a predetermined electrode pattern; and
with the photolithographic pattern as a mask, etching the metal boride film by using an ion beam to form the metal boride film into the predetermined electrode pattern.

2. The method for producing the memristor electrode according to claim 1, wherein the metal boride film has a purity of 99.9% or more.

3. The method for producing the memristor electrode according to claim 1, wherein the substrate is a silicon wafer.

4. The method for producing the memristor electrode according to any one of claims 1 to 3, wherein the metal boride film has a thickness of 20 nm to 100 nm.

5. The method for producing the memristor electrode according to claim 1, wherein the annealing processing comprises:
performing first annealing processing on the metal boride film at a first temperature for a first duration; and
performing second annealing processing on the metal boride film at a second temperature for a second duration, wherein the first temperature is higher than the second temperature and the first duration is shorter than the second duration.

6. The method for producing the memristor electrode according to claim 5, wherein the first annealing processing is performed in nitrogen gas.

7. The method for producing the memristor electrode according to claim 5 or 6, wherein the first temperature ranges from 900 °C to 1100 °C, and the first duration ranges from 1 second to 10 seconds.

8. The method for producing the memristor electrode according to any one of claims 5 to 7, wherein the second annealing processing is performed in a nitrogen-hydrogen mixed gas.

9. The method for producing the memristor electrode according to any one of claims 5 to 8, wherein the second temperature ranges from 400 °C to 430 °C, and the second duration ranges from 0.5 hour to 2 hours.

10. The method for producing the memristor electrode according to any one of claims 1 to 9, wherein a thickness of the photoresist layer is at least twice a thickness of the metal boride film.

11. The method for producing the memristor electrode according to claim 1, wherein the etching the metal boride film by using the ion beam comprises: bombarding the surface of the metal boride film by using an inert gas ion to remove part of the metal boride film.

12. The method for producing the memristor electrode according to claim 11, wherein the etching the metal boride film by using the ion has 10%-30% of over-etching.

13. The method for producing the memristor electrode according to claim 1, wherein the metal boride has a hexagonal crystal structure, and a boron atom plane and a metal atom plane in the crystal structure alternate to form a two-dimensional network structure.

14. The method for producing the memristor electrode according to any one of claims 1 to 13, wherein the metal boride film is a metal diboride film.

15. The method for producing the memristor electrode according to any one of claims 1 to 13, wherein the metal boride film is any one of titanium diboride, zirconium diboride, hafnium diboride and magnesium diboride.

16. A memristor electrode, wherein the memristor electrode is produced according to the producing method of any one of claims 1-15.

17. A memristor, comprising an upper electrode, a lower electrode and a resistive layer disposed between the upper electrode and the lower electrode, wherein the upper electrode and/or the lower electrode are the memristor electrodes according to claim 16.

18. A resistive memory, comprising: at least one memristor and a metal-oxide-semiconductor field-effect transistor for controlling the memristor, the memristor comprising an upper electrode, a lower electrode and a resistive layer disposed between the upper electrode and the lower electrode, wherein the upper electrode and/or the lower electrode are the memristor electrodes according to claim 16.

19. The resistive memory according to claim 18, wherein the metal-oxide-semiconductor field-effect transistor comprises a substrate, a source, a drain, a gate dielectric layer, a gate, and a spacer.

20. The resistive memory according to claim 19, wherein the drain is electrically connected with the lower electrode through a first metal connection line.

21. The resistive memory according to claim 18, wherein the resistive memory comprises a plurality of memristors arranged in a matrix form.

22. The resistive memory according to claim 21, wherein upper electrodes of the plurality of memristors arranged in the matrix form in a same row/column are respectively connected to a plurality of second metal connection lines in one-to-one correspondence, and the plurality of second metal connection lines are connected with an external circuit/ground terminal through a third metal connection line.

23. The resistive memory according to claim 22, wherein the external circuit comprises a row/column decoder, a write circuit, and/or an amplification circuit.
